Europäisches Patentamt

European Patent Office

Office européen des brevets

(11) Publication number: **0 069 429**
**B1**

# EUROPEAN PATENT SPECIFICATION

(45) Date of publication of patent specification: 20.09.89

(21) Application number: 82200826.4

(22) Date of filing: 02.07.82

(51) Int. Cl.⁴: **H 01 L 29/78,** H 01 L 29/10, H 01 L 29/06

(54) Insulated gate field effect transistor.

(30) Priority: 06.07.81 NL 8103218

(43) Date of publication of application:
12.01.83 Bulletin 83/02

(45) Publication of the grant of the patent:
20.09.89 Bulletin 89/38

(84) Designated Contracting States:
DE FR GB NL SE

(56) References cited:
DE-A-2 753 704
DE-A-2 903 534
FR-A-2 381 389
GB-A-2 077 494
GB-A-2 083 700
US-A-4 172 260
US-A-4 300 150

IEEE ELECTRON DEVICE LETTERS, vol. EDL-1,
no. 4, April 1980, pages 51-53, New York, US. S.
COLAK et al.: "Lateral DMOS power transistor
design"

(73) Proprietor: N.V. Philips' Gloeilampenfabrieken
Groenewoudseweg 1
NL-5621 BA Eindhoven (NL)

(72) Inventor: Ludikhuize, Adrianus Willem
c/o INT.OCTROOIBUREAU B.V. Prof.Holstlaan 6
NL-5656 AA Eindhoven (NL)

(74) Representative: Houbiers, Ernest Emile Marie
Gerlach et al
INTERNATIONAAL OCTROOIBUREAU B.V. Prof.
Holstlaan 6
NL-5656 AA Eindhoven (NL)

(56) References cited:
INTERNATIONAL ELECTRON DEVICES
MEETING, December 5-7, 1977, Technical
Digest, pages 399-401, IEEE, New York, US. J.
TIHANYI et al.: "DIMOS - A novel IC technology
with submicron effective channel MOSFET's"

IBM TECHNICAL DISCLOSURE BULLETIN, vol.
23, no. 11, April 1981, page 4988, New York,
US. C.G. JAMBOTKAR et al.: "High-voltage
MOSFET structure"

Courier Press, Leamington Spa, England.

# EP 0 069 429 B1

(56) References cited:

IEEE JOURNAL OF SOLID STATE CIRCUITS,
vol. SC-11, no. 6, December 1976, pages
809-817, New York, US. J.D. PLUMMER et al.:
"A monolithic 200-V CMOS analog switch"

IEEE JOURNAL OF SOLID STATE CIRCUITS,
vol. SC-16, no. 3, June 1981, pages 212-226,
New York, US. E. HABEKOTTE et al.: "A
coplanar CMOS power switch"

INTERNATIONAL ELECTRON DEVICES
MEETING, December 8-10, 1980, Washington,
Technical Digest, pages 87-90, IEEE, New York,
US. H.M.J. VAES et al.: "High voltag, high
current lateral devices"

THE INTERNATIONAL ELECTRON DEVICES
MEETING, December 7-9, 1981, Washington,
Technical Digest, pages 426-428, IEEE, New
York, US. E.H. STUPP et al.: "Low specific on -
resistance 400V LDMOST"

NEUES AUS DER TECHNIK, no. 6, December
1981, page 4, Vogel-Verlag, Würzburg, DE.
"Integrierte Hichspannungsschlatkreise"

## Description

The invention relates to a semiconductor device having a semiconductor body comprising a surface-adjoining first region of a first conductivity type in which an insulated gate field effect transistor is provided, having highly doped source and drain zones of the second, opposite conductivity type, a surface zone of the second conductivity type adjoining the drain zone and having a lower doping concentration than the drain zone, said surface zone extending in the direction of the source zone, a channel region of the first conductivity type present between said surface zone and the source zone, and a gate electrode present above the channel region and separated from the channel region by an electrically insulating layer, a field plate being provided between the source and drain zones and extending in the direction of the drain zone to above the said surface zone but not to above the drain zone and being insulated from the semiconductor surface, the said field plate having a connection conductor.

A semiconductor device of the kind described in the opening paragraph is known from Netherlands Patent Application No. 7713333 laid open to public inspection.

In order to increase the drain breakdown voltage of insulated gate field effect transistors, various measures have been suggested in the course of time, the object of all of which is to reduce the field strength at or near the surface in those places where there exists a danger of the occurrence of avalanche breakdown.

As a first measure it has been suggested to provide between the gate electrode and the highly doped drain zone a surface zone of the same conductivity type as and a lower doping concentration than the highly doped drain zone, which surface zone adjoins the drain zone, and between the source and drain zones is substantially everywhere thinner than the drain zone. From a given drain voltage (that is to say the voltage between the source and the drain zone) said surface zone is pinched off so that the surface field strength on the side of the drain zone is reduced and the drain breakdown voltage is increased.

An improvement of this structure by which disturbing influences of electric charges formed on the insulating layer are reduced is achieved by providing a field plate which is preferably connected to the source electrode and which extends to above the surface zone but at a distance from the highly doped drain zone. However, undesired instabilities may occur as a result of charge fluctuations on the uncovered part of the insulating layer present between the field plate and the highly doped drain zone.

In the above mentioned Netherlands Application 7713333 it is suggested, to prevent said instabilities, to provide a region of the same conductivity type between the said surface zone and the highly doped drain zone the doping concentration of which is between that of the drain zone and the said surface zone. The field plate extends up to above the said intermediately located region. As a result of the higher doping concentration of said intermediate region it is not pinched off and exerts no influence on the series resistance of the field effect transistor, while it is also less sensitive to the said charge fluctuations.

Although high drain breakdown voltages can be reached in this manner, the addition of such an extra intermediate region meets with disadvantages. For example, an extra doping step is necessary at any rate, which is technologically complicated.

One of the objects of the invention is to provide a semiconductor device having a field effect transistor of a new structure with a high drain breakdown voltage and stable electric properties and which can be used advantageously in integrated circuits and is suitable in particular for use in circuits in which the source and drain zones have a high voltage relative to the substrate, for example in source follower circuits.

The invention is *inter alia* based on the recognition of the fact that this object can be achieved by means of a structure in which the said surface zone is pinched off progressively on two sides, that is to say from the top and bottom sides, when the drain voltage increases.

A semiconductor device of the kind mentioned in the opening paragraph is characterized according to the invention in that the first region is an epitaxial layer forming with a substrate of the second conductivity type a *p-n* junction which inoperation is reverse biased, that a buried layer of the first conductivity type having a higher doping concentration than the epitaxial layer is provided between said epitaxial layer and the substrate and below at least the channel region and a part of the surface zone, said buried layer not extending below the drain zone, and that the field plate extends above the surface zone on insulating layer parts of a thickness increasing in the direction of the drain zone as a result of which in the direction of the drain zone successive parts of the surface zone are successively pinched off when the drain voltage increases.

In the semiconductor device according to the invention a progressive, phased, two-sided depletion of said surface zone is obtained in the direction from the source zone to the drain zone when the drain voltage increases. This phased two-sides depletion occurs between the epitaxial layer and the field plate and can be obtained even when only one surface zone is used, which can be manufactured in one single doping step. Furthermore, due to the presence of the buried layer, the field distribution is favourable influenced by reduction of the surface field strength.

It is to be noted that field plate as meant in this Application may consist of one single conductive layer or of mutually separated subfield plates which, if required, may each individually be contacted.

According to an important preferred embodiment the epitaxial layer has such a small doping concentration and thickness that at least near the drain zone it is depleted throughout its thickness at a drain voltage which is lower than the drain breakdown voltage, all this according to the so-called "RESURF" principle as described *inter alia* in Philips Journal of Research, Vol. 35, 1980 pp, 1-13. With this construction the highest breakdown voltages are reached.

The field plate is preferably spaced from the highly doped drain zone in order to avoid breakdown between field plate and drain zone *via* the insulating layer. The field plate is preferably electrically connected to the source electrode or to the gate electrode.

The thickness of the isolating layer on which the field plate is present may increase continuously in the direction of the drain zone. According to a third embodiment said thickness increases stepwise.

In order to increase the drain breakdown voltage the highly doped drain zone may be embedded in a part of the lower doped surface zone. As a result of this the influence of the edge curvature of the highly doped drain zone decreases.

In order to better control the phased depletion the doping concentration may increase from the surface zone in the direction of the drain zone, although techologically this is slightly more complicated. A further measure to increase the breakdown voltage may be that the drain electrode extends in the direction of the source zone to above the surface zone and thus serves as a field electrode. For a good operation of the device the source zone should have a potential which is substantially equal to that of the epitaxial layer although a difference of a few volts is acceptable. Preferably, however, the source zone is electrically connected to the epitaxial layer.

The invention will be described in greater detail with reference to a few embodiments and the drawing, in which

Figs. 1, 2 and 3 are diagrammatic cross-sectional views of various embodiments of a semiconductor device according to the invention,

Figs. 4 and 5 are diagrammatic cross-sectional views of integrated circuits in which the invention is used,

Figs. 6A and 6B show possible circuit diagrams comprising a semiconductor device according to the invention,

Fig. 7 is a diagrammatic plan view of a semiconductor device in accordance with the invention, and

Fig. 8 is a diagrammatic cross-sectional view taken on the line VIII-VIII of Fig. 7.

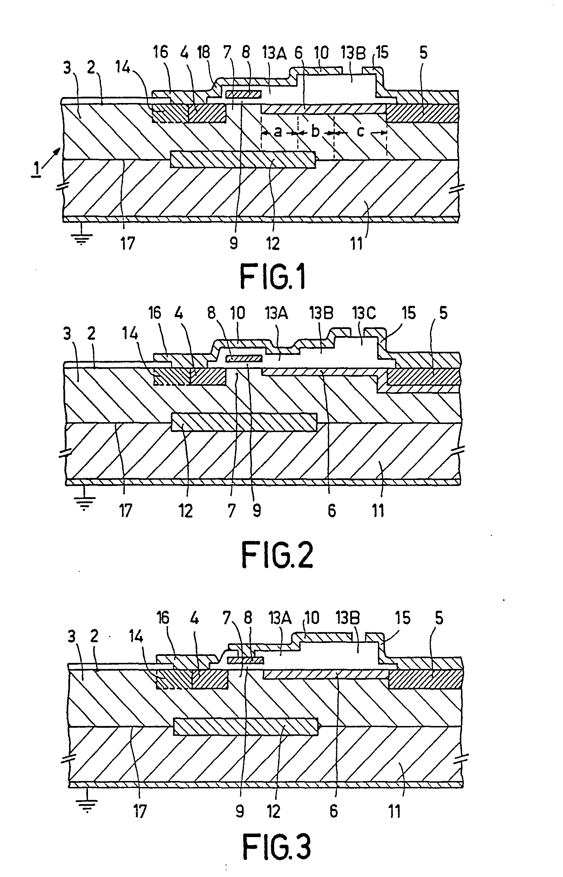

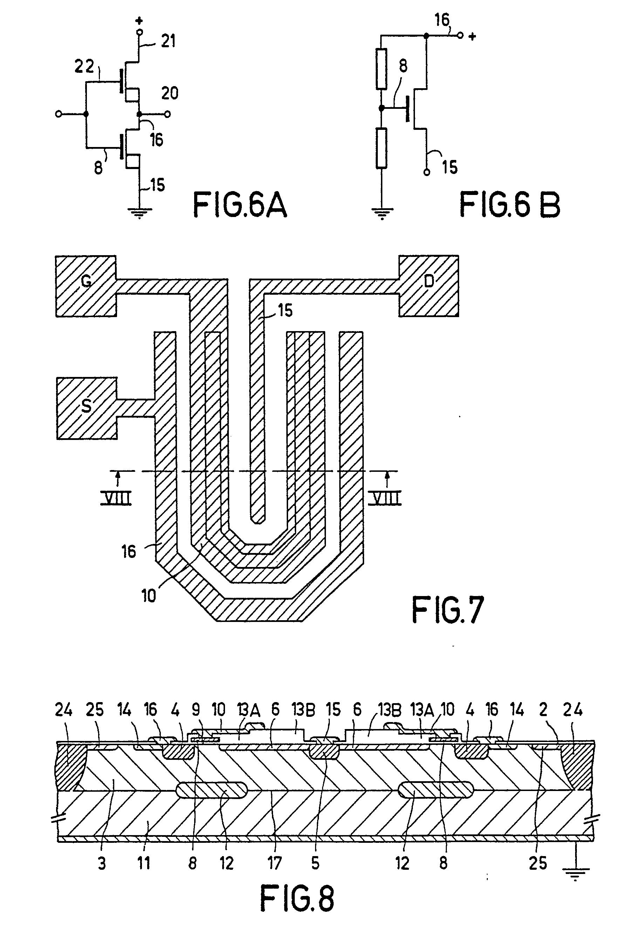

The figures are purely diagrammatic and are not drawn to scale. This applies in particular to the direction of thickness, Corresponding parts are generally referred to by the same reference numerals. Semiconductor regions of the same conductivity type (with the exception of gate electrodes consisting of polycrystalline silicon) are shaded in the same direction in the cross-sectional views. In the plan view of Fig. 7 the metal layers are shaded. Fig. 1 is a diagrammatic cross-sectional view of a part of a semiconductor device according to the invention. The device comprises a semiconductor body 1, in this example of silicon, having a region 3 of a first conductivity type, in this case the *n* conductivity type, which adjoins a surface 2 and in which an insulated gate field effect transistor is provided. The field effect transistor comprises highly doped source and drain zones 4 and 5 of the second opposite conductivity type, so in this example of the *p*-type. Furthermore a surface zone 6 of the second *p*-conductivity type adjoining the drain zone 5 is present having a lower doping concentration than the drain zone 5. The surface zone 6 extends in the direction of the source zone 4. Between said zone 6 and the source zone 4 the *n*-type channel region 7 of the field effect transistor is present which forms part of the region 3. Above the channel region 7 is present a gate electrode 8 of the field effect transistor, which gate electrode is separated from the channel region 7 by an electrically insulating layer, in this example a silicon oxide layer 9. The gate electrode 8 in this example is of polycrystalline silicon, but may also be of metal.

A conductive field plate 10, in this example a metal layer, is provided between the source and drain zones 4 and 5 and extends in the direction of the drain zone 5 to above the surface zone 6 but not to above the drain zone 5. The field plate 10 is insulated from the semiconductor surface 2 and is connected *via* a metal layer 18 to such a potential that the zone 6 is depleted from above when the drain voltage increases. In this example this purpose is achieved in that the field plate 10 is connected to the source electrode 16 *via* the metal layer part 18. The source electrode is connected to the region 3 *via* a highly doped contact zone 14.

According to the invention the first region 3 is formed by an epitaxial layer which is present on a substrate 11 of the second, so in this case *p*-conductivity type and forms therewith a *p-n* junction which in the operating condition is reverse biased. Between the epitaxial layer 3 and the substrate 11, and below the source zone 4, the channel region 7 and a part of the surface zone 6 there is a buried layer 12 of the first conductivity type, so in this example of the *n*-conductivity type, having a higher doping concentration than the epitaxial layer 3. The buried layer 12 does not extend to below the drain zone 5 and in this example is spaced from the drain zone 5. Furthermore the field plate 10 according to the invention extends above the surface zone 6 on insulating layer parts (13A, 13B) of a thickness increasing in the direction of the drain zone 5. As a result of this, with increasing values of the drain voltage, successive parts (*a, b, c;*) see fig. 1 of surface zone 6 are successively pinched off in the direction of the drain zone 5. As a result of this phased depletion the field distribution is influenced so that the field strength at the surface 2 is optimally reduced. As a result of this, higher drain breakdown voltages can be realized than in the known "extended drain" field effect transistors as described in the said Netherlands Patent Application 7713333. On the other hand, for the same drain breakdown voltage, a higher doping of the zone 6 may be used than in the known structure.

The field effect transistor structure may have various constructions. For example, fig. 2 is a diagrammatic cross-sectional view of a modified embodiment in which the field plate 10 extends over the oxide 13 in three steps 13A, B and C and in which the highly doped drain zone 5 is embedded in the surface zone 6, which further increases the drain breakdown voltage. For this purpose the drain electrode 15 in figs. 1 and 2 which extends as a field electrode in the direction of the source zone 4 to above the surface zone 6 also cooperates.

As shown in figs. 1 and 2 the field plate 10 is preferably not extended to above the drain zone 5 but is spaced therefrom, since otherwise breakdown might occur between the field plate 10 and the drain zone 5 via the insulating layer 13.

The field plate 10 need not be connected to the source electrode 16 but, for example as shown in fig. 3, may be connected instead thereof to the gate electrode 8. It is of importance that in the operating condition the potentials of the field plate 10 and of the epitaxial layer 3 on both sides of the surface zone 6 should have the same sign relative to said zone so that the zone 6 is two-sided depleted when the drain voltage increases. In order to achieve this the field plate 10 may also be connected, if desired, via a separate connection conductor to a suitable potential. The field plate may also consist of separated sub-field plates which are each on a different oxide thickness and are each individually connected to a desired potential.

Although in figs. 1, 2 and 3 the thickness of the insulating layer 13 on which the field plate 10 is present increases stepwise in the direction of the drain zone, this need not be the case. The thickness of the insulating layer 13 may also increase gradually in the direction of the drain zone, although technologically this is less simple to realise.

The endeavoured increase of the drain breakdown voltage is optimally realised when the epitaxial layer 3 has such a small doping concentration and thickness that at least near the drain zone it is depleted throughout its thickness at a drain voltage which is lower than the drain breakdown voltage. For this purpose a doping in the order of magnitude of $10^{12}$ doping atoms per $cm^2$ over the thickness of the layer 3 is generally necessary. By means of this technique which is described elaborately in the already mentioned articles by Appels et al in Philips Journal of Research, Vol. 35, no. 1, 1980, pp. 1-13 and which is known as "RESURF" (Reduced Surface Field) technique, a comparatively thin epitaxial layer 3 may also be used for high drain breakdown voltages.

The surface zone 6 may have the same doping concentration everywhere in the direction from the source to the drain zone, that is to say the same doping profile in the direction of thickness. In certain circumstances, however, it may sometimes be preferable to cause the doping concentration to increase in the direction of the drain zone as a result of which an extra possibility is obtained of controlling the said phased depletion of the zone 6.

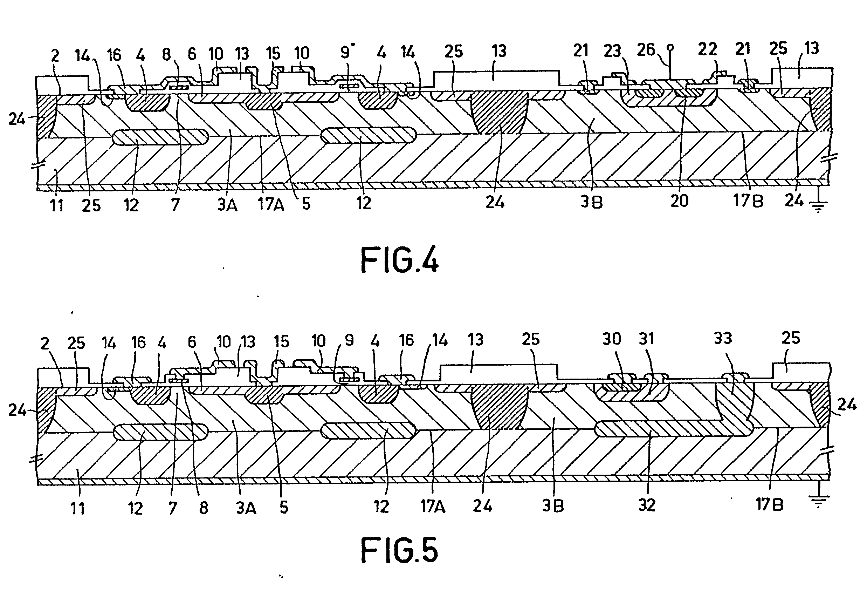

The field effect transistor structure according to the invention is particularly suitable for use in a process in which a field effect transistor of the complementary type is also realised. This is shown in Fig. 4 which is a cross-sectional view of a part of an integrated circuit. In a first island-shaped part 3A of the epitaxial layer 3 a field effect transistor is present having a construction according to the invention and shown here symmetrically around the drain zone 5. Corresponding parts in figs. 1 to 4 are referred to by the same reference numerals. In an adjacent second island-shaped part 3B of the epitaxial layer is present an n-channel field effect transistor which is complementary to the first field effect transistor of the p-channel type, in this example in the form of a so-called lateral D-MOST having an n-type source zone 20, an n-type drain zone 21, a gate electrode 22 and a p-type channel region 23. When the epitaxial layer 3 satisfies the RESURF condition, this D-MOST is also suitable for high voltages. This field effect transistor is constructed symmetrically around the source electrode 26. The islands 3A and 3B are separated from each other by p-type separation diffusions 24 to which thin lower doped p-type extension zones 25 have been added in this example. These serve for the depletion of the layer 3 near the diffusion zones 24 both from the top and from the bottom, so as to rapidly reach the above-mentioned "RESURF" depletion effect. The zones 25 themselves in the operating condition are depleted at least for the greater part already at comparatively low reverse voltage between the islands 3A, B and the substrate 11. They may also be useful to prevent that interconnections on the oxide in the proximity of the insulating zones 24 reduce the breakdown voltage between the island and said zones 24. The zones 25 may be manufactured in the same process step as the zones 6. The zones 14 and 21, if desired, may also be formed simultaneously, as well as the zones 4, 5 and 23. The epitaxial island 3B may be considered to belong to the drain region of the lateral DMOST.

The field effect transistor structure according to the invention is also very suitable for being manufactured in a process in which bipolar transistors are also formed. As an example, fig. 5 is a cross-sectional view of a part of an integrated circuit in which a p-channel field effect transistor of the type shown in fig. 3, in this case again considered to be symmetrical with respect to the drain electrode 5, is present in the first island-shaped part 3A of the epitaxial layer 3, and that a bipolar transistor is provided in an adjacent second island-shaped part 3B. Corresponding parts of the field effect transistors are referred to by the same reference numerals in figs. 1 to 5. In this example the bipolar transistor is a vertical *npn*-transistor having an *n*-type emitter zone 30 and a *p*-type base zone 31, the collector zone of which transistor is formed by the island 3B and the *n*-type buried layer 32 which is contacted at the surface *via* a diffused *n*-type connection zone 33. If desired, the emitter zone 30 may be formed simultaneously with the zones 14 and the base zone 31 may be formed simultaneously with the zones 4 and 5.

Of particular importance is the field effect transistor structure according to the invention in applications in which both the source and the drain electrode are at a high voltage, for example more than 200 Volts with respect to the substrate 11. This is the case, for example when the field effect transistor is connected as a source follower (fig. 6A) or as a current source (fig. 6B). In Figs. 6A and 6B the reference numerals correspond to those of Figs. 1 to 5. In these cases, punch-through of the substrate 11 to the source zone 4 is avoided *inter alia* by the comparatively high resistivity of the substrate (preferably 30-50 Ohm.cm).

Many other combinations are possible and the examples given here only serve for purposes of illustration. As regards the choice of the conductivity type, resistivity and thickness of the various layers and zones, as well as the geometry (layout) of the semiconductor device in accordance with the invention, those skilled in the art may choose the best combinations from many possibilities, dependent upon the use for illustration, finally, a detailed example of a readily operating field effect transistor structure in accordance with the invention will be described with reference to figs. 7 and 8.

Fig. 7 is a diagrammatic plan view and fig. 8 is a diagrammatic cross-sectional view taken on the line VIII-VIII of a field effect transistor structure in accordance with the invention having a U-shaped geometry. In this example the field plate 10 is connected to the gate electrode 8. The device is of the type shown in Fig. 3. The substrate 11 is of *p*-type silicon having a resistivity of 30 Ohm.cm. The *n*-type epitaxial layer 3 has a resistivity of approximately 4 Ohm. cm and a thickness of approximately 15 µm. The buried *n*-type layer 12 has a spacing of approximately 10 µm to the surface 2. The surface zone 6 has a thickness of approximately 2 µm and an overall doping of $1.8 \times 10^{12}$ atoms per cm$^2$; this zone is preferably made by ion implantation. Otherwise the semiconductor devices shown in figs. 1 to 5, 7 and 8 can all be manufactured by means of different methods usual in semiconductor technology.

The field effect transistor shown in figs. 7 and 8 uses two-sided depletion of the epitaxial layer 3 and can operate at drain voltages up to 250 Volts and higher. As a result of the comparatively low doping concentration of the substrate 11 no punch-through occurs, not even at a high substrate voltage (source-follower application) since the depletion zone of the *pn*-junction 17 can penetrate comparatively far into the substrate.

The field plate 10 is present on an oxide layer 13 with only one step; in order to reach an even better phased pinching of the surface zone 6 the number of steps may be increased at will.

The invention is not limited to the examples described. For example, the conductivity types mentioned in the examples may all be replaced simultaneously by their opposite ones. The materials for the conductive and insulating layers may also be replaced by other ones, while as a semiconductor material other semiconductor materials, for example germanium or $A_{III}B_V$ compounds, for example gallium arsenide, may be used instead of silicon.

## Claims

1. A semiconductor device having a semiconductor body comprising a surface-adjoining first region of a first conductivity type in which an insulated gate field effect transistor is provided, having highly doped source and drain zones of the second opposite conductivity type, a surface zone of the second conductivity type adjoining the drain zone and having a lower doping concentration than the drain zone, said surface zone extending in the direction of the source zone, a channel region of the first conductivity type present between said surface zone and the source zone, and a gate electrode present above the channel region and separated from the channel region by an electrically insulating layer, a field plate being provided between the source and drain zones and extending in the direction of the drain zone to above the said surface zone but not to above the drain zone and being insulated from the semiconductor surface, said field plate comprising a connection conductor, characterized in that the first region is an epitaxial layer forming with a substrate of the second conductivity type a *p-n* junction which in operation is reverse biased, that a buried layer of the first conductivity type having a higher doping concentration than the epitaxial layer is provided between said epitaxial layer and the substrate and below at least the channel region and a part of the surface zone, said buried layer not extending below the drain zone, and that the field plate extends above the surface zone on insulating layer parts of a thickness increasing the direction of the drain zone, as a result of which in the direction of the drain zone successive parts of the surface zone are successively pinched off when the drain voltage increases.

2. A semiconductor device as claimed in Claim 1, characterized in that the epitaxial layer has such a small doping concentration and thickness that at least in the vicinity of the drain zone it is depleted throughout its thickness at a drain voltage which is lower than the drain breakdown voltage.

3. A semiconductor device as claimed in Claim 1 or 2, characterized in that the field plate is laterally spaced from the drain zone.

4. A semiconductor device as claimed in any of the preceding Claims, characterized in that the field plate is electrically connected to the source electrode.

5. A semiconductor device as claimed in any of the Claims 1 to 3, characterized in that the field plate is connected electrically to the gate electrode.

6. A semiconductor device as claimed in any of the preceding Claims, characterized in that the thickness of the insulating layer on which the field plate is present increases stepwwise in the direction of the drain zone.

7. A semiconductor device as claimed in any of the preceding Claims, characterized in that the highly doped drain zone is embedded in a part of the said surface zone.

8. A semiconductor device as claimed in any of the preceding Claims, characterized in that the source zone is electrically connected to the epitaxial layer.

9. A semiconductor device as claimed in any of the preceding Claims, characterized in that the doping concentration of the said surface zone increases in the direction of the drain zone.

10. A semiconductor device as claimed in any of the preceding Claims, characterized in that the drain electrode extends in the direction of the source zone to above the surface zone.

11. A semiconductor device as claim an of the preceding Claims, characterized in that the insulated gate field effect transistor is present in a first island-shaped part of the epitaxial layer and that in an adjacent second island-shaped part of the epitaxial layer a second field effect transistor which is complementary to the first field effect transistor is provided, the epitaxial layer belonging to the drain region of said second field effect transistor.

12. A semiconductor device as claimed in any of the preceding Claims, characterized in that the insulated gate field effect transistor is present in a first island-shaped part of the epitaxial layer and that in an adjacent further island-shaped part of the epitaxial layer a bipolar transistor is provided, the epitaxial layer forming an active zone of said bipolar transistor.

## Patentansprüche

1. Halbleiteranordnung mit einem Halbleiterkörper, der ein an die Oberfläche grenzendes erstes Gebiet von einem ersten Leitfähigkeitstyp enthält, in dem ein Feldeffekttransistor mit isoliertem Steuerelektrode und hochdotierten Quellen- und Abzugszonen vom zweiten entgegengesetzten Leitfähigkeitstyp vorgesehen ist, der eine Oberflächenzone vom zweiten Leitfähigkeitstyp enthält, die an die Abzugszone grenzt, eine niedrigere Dotierungskonzentration als die Abzugszone hat und sich in der Richtung der Quellenzone erstreckt, der ein Kanalgebiet vom ersten Leitfähigkeitstyp zwischen der Oberflächenzone und der Quellenzone enthält und der eine Steuerelektrode über dem Kanalgebiet enthält, die durch eine elektrisch isolierende Schicht vom Kanalgebiet getrennt ist, wobei zwischen der Quellen- und der Abzugszone eine Feldplatte angeordnet ist, die sich in der Richtung der Abzugszone bis ber der Oberflächenzone, aber nicht bis uber der Abzugszone erstreckt, und dabei von der Halbleiterfläche isoliert ist, wobei diese Feldplatte einen Anschlußleiter enthält, dadurch gekennzeichnet. daß das erste Gebiet eine Epitaxialschicht ist, die mit einem Substrat vom zweiten Leitfähigkeitstyp einen p-n-Übergang bildet, der im Betrieb in Sperrichtung vorgespannt ist, daß eine begrabene Schicht vom ersten Leitfähigkeitstyp mit einer höheren Dotierungskonzentration als die der Epitaxialschicht zwischen diesem Epitaxialschicht und dem Substrat und dabei unter wenigstens dem Kanalgebiet und einem Teil der Oberflächenzone angeordnet ist, wobei sich die begrabene Schicht nicht bis unter der Abzugszone erstreck, und daß die Feldplatte sich über der Oberflächenzone auf Teilen der isolierenden Schicht mit einer Dicke erstreckt, die in Richtung der Abzugszone größer wird, wodurch in Richtung der Abzugszone aufeinanderfolgende Teile der Oberflächenzone bei ansteigender Abzugsspannung einen nach dem anderen gedrosselt werden.

2. Halbleiteranordnung nach Anspruch 1, dadurch gekennzeichnet, daß die Epitaxialschicht eine so geringe Dotierungskonzentration und Dicke hat, daß wenigstens in der Nähe der Abzugszone diese Schicht durch die ganze Dicke bei einer Abzugsspannung verarmt wird, die niedriger als die Abzugsdurchschlagsspannung ist.

3. Halbleiteranordnung nach Anspruch 1 oder 2, dadurch gekennzeichnet, daß die Feldplatte in seitlicher Richtung im Abstand von der Abzugszone angeordnet ist.

4. Halbleiteranordnung nach einem oder mehreren der vorangehenden Ansprüche, dadurch gekennzeichnet, daß die Feldplatte mit der Quellenelektrode elektrisch verbunden ist.

5. Halbleiteranordnung nach einem oder mehreren der Ansprüche 1 bis 3, dadurch gekennzeichnet daß die Feldplatte mit der Gate-Elektrode elektrisch verbunden ist.

6. Halbleiteranordnung nach einem oder mehreren der vorangehenden Ansprüche, dadurch gekennzeichnet daß die Dicke der isolierenden Schicht, auf der die Feldplatte sich befindet, in Richtung der Abzugszone schrittweise größer wird.

7. Halbleiteranordnung nach einem oder mehreren der vorangehenden Ansprüche, dadurch gekennzeichnet, daß die hochdotierte Abzugszone in einen Teil der Oberflächenzone eingebettet ist.

8. Halbleiteranordnung nach einem oder mehreren der vorangehenden Ansprüche, dadurch gekennzeichnet, daß die Quellenzone mit, der Epitaxialschicht elektrisch verbunden ist.

9. Halbleiteranordnung nach einem oder mehreren der vorangehenden Ansprüche, dadurch gekennzeichnet. daß die Dotierungskonzentration der Oberflächenzone sich in Richtung der Abzugszone erhöht.

10. Halbleiteranordnung nach einem oder mehreren der vorangehenden Ansprüche, dadurch gekennzeichnet, daß die Abzugselektrode sich in Richtung der Quellenzone bis über der Oberflächenzone erstreckt.

11. Halbleiteranordnung nach einem oder mehreren der vorangehenden Ansprüche dadurch gekennzeichnet, daß der Feldeffekttransistor mit isoliertem Gate sich in einem inselförmigen Teil der Epitaxialschicht befindet, und daß in einem benachbarten inselförmigen Teil der Epitaxialschicht ein zweiter Feldeffekttransistor angeordnet ist, der dem ersten Feldeffekttransistor komplementär ist, wobei die Epitaxialschicht zum Abzugsgebiet des zweiten Feldeffekttransistors gehört.

12. Halbleiteranordnung nach einem oder mehreren der vorangehenden Ansprüche, dadurch gekennzeichnet, daß der Feldeffekttransistor mit isoliertem Gate sich in einem ersten inselförmigen Teil der Epitaxialschicht befindet, und daß in einem benachbarten weiteren inselförmigen Teil der Epitaxialschicht ein bipolarer Transistor angeordnet ist, wobei die Epitaxialschicht eine aktive Zone des bipolaren Transistors bildet.

**Revendications**

1. Dispositif semiconducteur comportant un corps semiconducteur présentant une première région adjacente à une surface d'un premier type de conductivité dans laquelle est réalisé un transistor à effet de champ à porte isolée, présentant des zones de source et de drain fortement dopées du second type de conductivité opposé, une zone superficielle du second type de conductivité adjacente à la zone de drain et présentant une concentration de dopage plus faible que celle de la zone de drain, ladite zone superficielle s'étendant dans la direction de la zone de source, une région de canal du premier type de conductivité présente entre ladite zone superficielle et la zone de source, et une électrode de porte présente au-dessus de la région de canal et séparée de la région de canal par une couche électriquement isolante, une plaque de champ étant disposée entre les zones de source et de drain et s'étendant dans la direction de la zone de drain jusqu'au-dessus de ladite zone superficielle mais non au-dessus de la zone de drain et étant isolée de la surface semiconductrice, ladite plaque de champ présentant un conducteur de connexion, caractérisé en ce que la première région est une couche épitaxiale formant avec un substrat du second type de conductivité une jonction *pn*, qui est polarisée en inverse dans l'état de fonctionnement, en ce qu'une couche enterrée du premier type de conductivité présentant une concentration de dopage plus élevée que la couche épitaxiale est disposée entre ladite couche épitaxiale et le substrat et au-dessous d'au moins la région de canal et une partie de la zone superficielle, ladite couche enterrée ne s'étendant pas au-dessous de la zone de drain, et en ce que la plaque de champ s'étend au-dessus de la zone superficielle sur les parties de couche isolante d'une épaisseur qui augmente dans la direction de la zone de drain de sorte que dans la direction de la zone de drain, les parties successives de la zone superficielle sont successivement pincées lorsque la tension de drain augmente.

2. Dispositif semiconducteur selon la revendication 1, caractérisé en ce que la couche épitaxiale présente une concentration de dopage et une épaisseur suffisamment faibles pour qu'au moins à proximité de la zone de drain, elle soit appauvrie sur toute son épaisseur dans le cas d'une tension de drain inférieure à la tension de claquage de drain.

3. Dispositif semiconducteur selon la revendication 1 ou 2, caractérisé en ce que la plaque de champ est espacée latéralement de la zone de drain.

4. Dispositif semiconducteur selon l'une des revendications précédentes, caractérisé en ce que la plaque de champ est connectée électriquement à l'électrode de source.

5. Dispositif semiconducteur selon l'une des revendications 1 à 3, caractérisé en ce que la plaque de champ est connectée électriquement à l'électrode de porte.

6. Dispositif semiconducteur selon l'une des revendications précédentes, caractérisé en ce que l'épaisseur de la couche isolante sur laquelle est présente la plaque de champ augmente par parties dans la direction de la zone de drain.

7. Dispositif semiconducteur selon l'une des revendications précédentes, caractérisé en ce que la zone de drain fortement dopée est noyée dans une partie de ladite zone superficielle.

8. Dispositif semiconducteur selon l'une des revendications précédentes, caractérisé en ce que la zone de source est connectée à la couche épitaxiale.

9. Dispisitif semiconducteur selon l'une des revendications précédentes, caractérisé en ce que la concentration de dopage de ladite zone superficielle augmente dans la direction de la zone de drain.

10. Dispositif semiconducteur selon l'une des revendications précédentes, caractérisé en ce que l'électrode de drain s'étend dans la direction de la zone de source jusqu'au-dessus de la zone superficielle.

11. Dispositif semiconducteur selon l'une des revendications précédentes, caractérisé en ce que le transistor à effet de champ à porte isolée est présent dans une première partie en forme d'îlot de la couche épitaxiale et en ce que dans une deuxième partie en forme d'îlot adjacente de la couche épitaxiale est présent un second transistor à effet de champ qui est complémentaire au premier transistor à effet de champ, la couche épitaxiale appartenant à la région de drain dudit second transistor à effet de champ.

12. Dispositif semiconducteur selon l'une des revendications précédentes, caractérisé en ce que le transistor à effet de champ à porte isolée est présent dans une première partie en forme d'îlot de la couche épitaxiale et en ce que dans une autre partie en forme d'îlot adjacente de la couche épitaxiale est réalisé un transistir bipolaire, la couche épitaxiale formant une zone active dudit transistor bipolaire.

FIG.1

FIG.2

FIG.3

FIG.4

FIG.5

2

FIG.6A

FIG.6 B

FIG.7

FIG.8

3